# EUROPEAN PATENT APPLICATION

(11) **EP 4 760 313 A1**
(43) Date of publication of application: **17.06.2026**
(21) Application number: 25762354.6
(22) Date of filing: 25.02.2025
(51) Int. Cl.: G01R 31/392, G01R 31/389, G01R 27/08, G01R 31/3842, G01R 19/10, G01R 19/165, B60L 58/16

(54) **APPARATUS AND METHOD FOR DIAGNOSING BATTERY**

(30) Priority: 27.02.2024 KR 20240028122
(71) Applicant: LG Energy Solution, Ltd., Seoul 07335 (KR)
(72) Inventor: CHOI, Dong-In, Daejeon 34122 (KR); YU, Hye-In, Daejeon 34122 (KR); KIM, Yong-Jun, Daejeon 34122 (KR)
(74) Representative: Goddar, Heinz J.
(86) International application number: PCT/KR2025/002628
(87) International publication number: WO 2025/183437

(57) **Abstract**

Disclosed is an apparatus for diagnosing a battery, which includes a profile obtaining unit configured to obtain a charging profile representing a voltage change of a battery in a charging process; and a control unit configured to calculate a voltage change amount of the battery at a point in time when charging starts in the charging profile, calculate a target resistance of the battery based on the calculated voltage change amount, and diagnose a state of the battery by comparing the target resistance with a first resistance profile in which a target resistance of the battery calculated in a previous charging cycle is stored.

## Description

### TECHNICAL FIELD

This application is based on and claims priority from Korean Patent Application No. 10-2024-0028122, filed on February 27, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of the battery according to a resistance calculated in a charging process.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, technology to accurately diagnose the current state of the battery is required.

In particular, it is necessary to prevent the phenomenon that lithium is deposited on the surface of the negative electrode (lithium plating). The lithium deposited on the surface of the negative electrode causes side reactions with the electrolyte and changes in the kinetic balance of the battery, which causes battery degradation.

In addition, lithium plating may cause swelling of the battery in which the battery is inflated. If swelling occurs in the battery, the center portion of the battery swells more than the edges of the battery, which may cause an uneven pressure distribution in the battery. This may cause problems such as a decrease in battery performance and a sudden death phenomenon in which the electrical connection is momentarily disconnected.

### DISCLOSURE

### Technical Problem

The present disclosure is designed to solve the problems of the related art, and therefore the present disclosure is directed to providing an apparatus and method for diagnosing a battery at risk of sudden death based on the resistance of the battery generated during a charging process.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

In one aspect of the present disclosure, there is provided an apparatus for diagnosing a battery, comprising: a profile obtaining unit configured to obtain a charging profile representing a voltage change of a battery in a charging process; and a control unit configured to calculate a voltage change amount of the battery at a point in time when charging starts in the charging profile, calculate a target resistance of the battery based on the calculated voltage change amount, and diagnose a state of the battery by comparing the target resistance with a first resistance profile in which a target resistance of the battery calculated in a previous charging cycle is stored.

The control unit may be configured to determine a first resistance section based on the first resistance profile and diagnose the state of the battery by comparing the first resistance section with the target resistance.

The control unit may be configured to determine a first resistance line for a plurality of resistances included in the first resistance profile and determine the first resistance section by adding a preset resistance threshold value to the determined first resistance line.

The control unit may be configured to diagnose the state of the battery as a normal state when the target resistance belongs to the first resistance section.

The control unit may be configured to diagnose the state of the battery as an abnormal state when the target resistance does not belong to the first resistance section.

The control unit may be configured to calculate a sub-voltage change amount between a voltage of the battery immediately after the charging starts and a voltage at a point in time when the charging is performed for a preset time in the charging profile, calculate a sub-resistance of the battery based on the calculated sub-voltage change amount, and diagnose the state of the battery based on the target resistance and the sub-resistance.

The control unit may be configured to determine a second resistance section based on a second resistance profile in which a sub-resistance of the battery calculated at the previous charging cycle is stored and diagnose the state of the battery based on the result of comparing the first resistance section with the target resistance and the result of comparing the second resistance section with the sub-resistance.

The control unit may be configured to determine a second resistance line for a plurality of resistances included in the second resistance profile and determine the second resistance section by adding a preset resistance threshold value to the determined second resistance line.

The control unit may be configured to diagnose the state of the battery as a normal state when the target resistance belongs to the first resistance section or the sub-resistance belongs to the second resistance section.

The control unit may be configured to diagnose the state of the battery as an abnormal state when the target resistance does not belong to the first resistance section and the sub-resistance does not belong to the second resistance section.

The control unit may be configured to calculate the voltage change amount by calculating a difference between an initial voltage of the battery just before the charging starts and a voltage of the battery immediately after the charging starts.

The control unit may be configured to calculate an initial resistance based on the voltage change amount and a charging current of the charging process, compare an initial SOC of the battery just before the charging starts with a preset target SOC, and calculate the target resistance based on the initial resistance according to the comparison result.

The control unit may be configured to determine the initial resistance as the target resistance when the initial SOC is equal to the target SOC.

The control unit may be configured to calculate the target resistance from the initial resistance based on a resistance table preset to indicate a resistance ratio for each SOC, when the initial SOC is different from the target SOC.

The control unit may be configured to calculate a total resistance for the battery by dividing the initial resistance by a resistance ratio corresponding to the initial SOC in the resistance table and determine the target resistance for the battery by multiplying the total resistance by a resistance ratio corresponding to the target SOC in the resistance table.

In another aspect of the present disclosure, there is provided a battery pack comprising the apparatus for diagnosing a battery according to an embodiment of the present disclosure.

In still another aspect of the present disclosure, there is provided a vehicle comprising the apparatus for diagnosing a battery according to an embodiment of the present disclosure.

In still another aspect of the present disclosure, there is provided a method for diagnosing a battery, comprising: a profile obtaining step of obtaining a charging profile representing a voltage change of a battery in a charging process; a voltage change amount calculating step of calculating a voltage change amount of the battery at a point in time when charging starts in the charging profile; a target resistance calculating step of calculating a target resistance of the battery based on the calculated voltage change amount; and a diagnosing step of diagnosing a state of the battery by comparing the target resistance with a first resistance profile in which a target resistance of the battery calculated in a previous charging cycle is stored.

### Advantageous Effects

According to one aspect of the present disclosure, the apparatus for diagnosing a battery may non-destructively diagnose the state of a battery based on the resistance behavior of the battery.

In particular, the apparatus for diagnosing a battery may predict in advance whether a battery is likely to experience sudden death based on the resistance of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a charging profile according to an embodiment of the present disclosure.
FIG. 3 is an enlarged view showing a charging protocol of FIG. 2.
FIG. 4 is a diagram schematically showing a first resistance profile according to an embodiment of the present disclosure.
FIG. 5 is an enlarged view showing a first resistance profile of FIG. 4.
FIG. 6 is a diagram schematically showing a capacity retention rate of a battery according to an embodiment of the present disclosure.
FIG. 7 is a diagram schematically showing a resistance table according to an embodiment of the present disclosure.
FIG. 8 is a diagram schematically showing a second resistance profile according to an embodiment of the present disclosure.
FIG. 9 is an enlarged view showing a second resistance profile of FIG. 8.
FIG. 10 is a diagram schematically showing a battery pack according to another embodiment of the present disclosure.
FIG. 11 is a diagram schematically showing a vehicle according to still another embodiment of the present disclosure.
FIG. 12 is a diagram for schematically illustrating a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

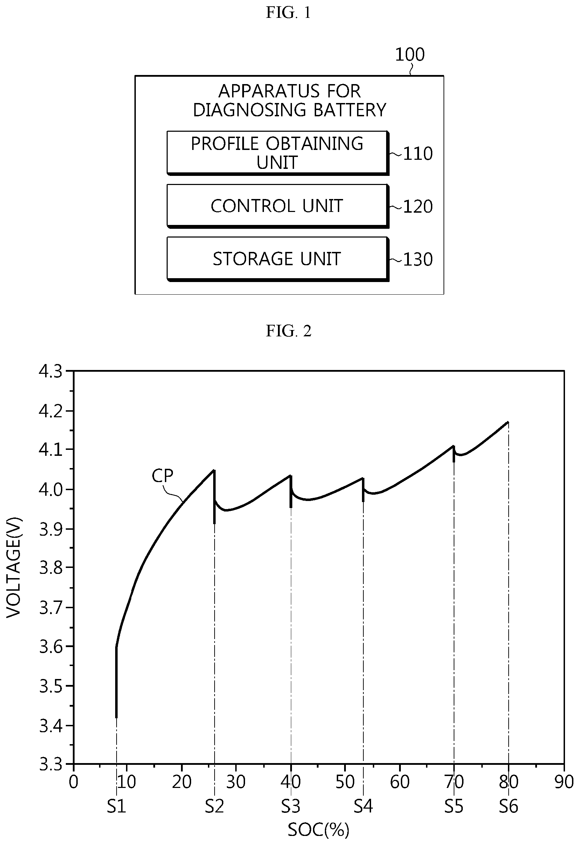

FIG. 1 is a diagram schematically showing an apparatus for diagnosing a battery according to an embodiment of the present disclosure.

Referring to FIG. 1, the apparatus for diagnosing a battery may include a profile obtaining unit and a control unit.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a charging profile CP representing a voltage change of a battery in a charging process.

Specifically, the charging profile CP may be a profile representing a voltage change according to time or capacity of the battery from the start time of charging to the end time of charging in the charging process. For example, the charging profile CP may be a profile representing a correspondence between charging time and voltage. As another example, the charging profile CP may be a profile representing a correspondence between SOC (State Of Charge) and voltage. As still another example, the charging profile CP may be a profile representing a correspondence between capacity and voltage.

Here, since the charging time, the capacity according to the charging time, and the SOC according to the charging time are factors for time that are replaceable with each other, there is no special limitation on the charging profile CP. However, hereinafter, for the convenience of explanation, the charging profile CP will be explained as a profile that represents the correspondence between SOC and voltage.

For example, the profile obtaining unit 110 may directly receive the charging profile CP from the outside. That is, the profile obtaining unit 110 may obtain the charging profile CP by receiving the charging profile CP by being connected to the outside by wire and/or wirelessly.

As another example, the profile obtaining unit 110 may receive battery information about the voltage and SOC of the battery. Also, the profile obtaining unit 110 may generate a charging profile CP based on the received battery information. That is, the profile obtaining unit 110 may obtain the charging profile CP by directly generating the charging profile CP based on battery information.

FIG. 2 is a diagram schematically showing a charging profile CP according to an embodiment of the present disclosure. In the embodiment of FIG. 2, the charging profile CP may be expressed as an X-Y graph in which the X-axis is set to SOC and the Y-axis is set to voltage.

Specifically, the embodiment of FIG. 2 is a charging profile CP of a battery that is rapidly charged. For example, charging of the battery starts at SOC S1 (%), and rapid charging of the battery ends at SOC S6 (%). Also, the battery is rapidly charged while the charging C-rate decreases at SOCs S2 (%), S3 (%), S4 (%), and S5 (%). That is, the charging C-rate of the SOC section of S1 (%) to S2 (%) is greater than the charging C-rate of the SOC section of S2 (%) to S3 (%). The C-rate of the SOC section of S2 (%) to S3 (%) is greater than the C-rate of the SOC section of S3 (%) to S4 (%). The C-rate of the SOC section of S3 (%) to S4 (%) is greater than the C-rate of the SOC section of S4 (%) to S5 (%). The C-rate of the SOC section of S4 (%) to S5 (%) is greater than the C-rate of the SOC section of S5 (%) to S6 (%).

The profile obtaining unit 110 may be connected to communicate with the control unit 120. For example, the profile obtaining unit 110 may be connected to the control unit 120 by wire and/or wirelessly. The profile obtaining unit may transmit the obtained charging profile CP to the control unit 120.

The control unit 120 may be configured to calculate the voltage change amount of the battery at the point in time when charging is started in the charging profile CP.

Specifically, the battery may be in a no-load state just before charging begins. Therefore, the initial voltage of the battery just before charging begins is OCV (Open Circuit Voltage).

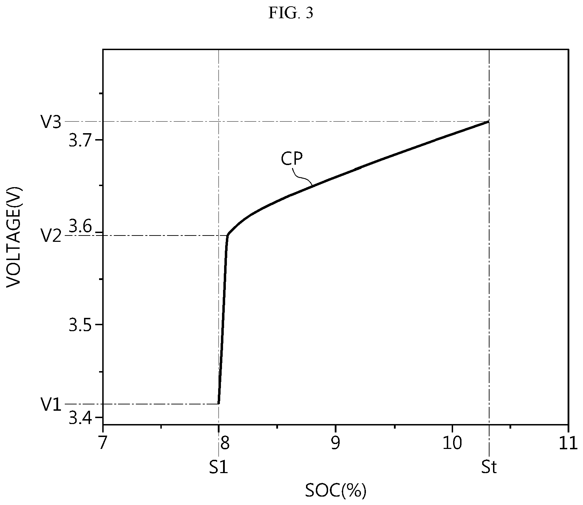

FIG. 3 is an enlarged view showing a charging protocol of FIG. 2. For example, the SOC of the battery just before charging begins is S1 (%) and the voltage is V1 (V).

In addition, when charging starts, the voltage of the battery increases rapidly compared to the initial voltage due to the internal resistance of the battery. For example, it is assumed that the terminal voltage of the battery is V, the initial voltage is OCV, the charging current is I, and the internal resistance of the battery is R. Here, the terminal voltage of the battery may be expressed according to the formula "V=OCV+IR". That is, immediately after charging starts, the voltage of the battery may increase by "IR".

The control unit 120 may be configured to calculate a voltage change amount by calculating the difference between the initial voltage of the battery just before charging starts and the voltage of the battery immediately after charging starts.

Specifically, the control unit 120 may calculate the voltage change amount by calculating the difference between the OCV of the battery just before charging starts and the terminal voltage of the battery immediately after charging starts.

For example, in the embodiment of FIG. 3, the control unit 120 may calculate the voltage change amount by calculating the formula "V2-V1".

The control unit 120 may be configured to calculate the target resistance of the battery based on the calculated voltage change amount.

The control unit 120 may be configured to calculate the target resistance based on the voltage change amount and the charging current of the charging process.

Specifically, the control unit 120 may calculate the target resistance based on the voltage change amount and the charging current using Ohm's law. For example, it is assumed that the voltage change amount is △V and the charging current is I. The control unit 120 may calculate the target resistance by calculating the formula "△V ÷ I".

For example, in the embodiments of FIGS. 2 and 3, it is assumed that the charging current for the SOC section of S1 (%) to S2 (%) is I. The control unit 120 may calculate the value obtained by dividing the voltage change amount (V2-V1) by the charging current (I) as the target resistance.

The control unit 120 may be configured to diagnose the state of the battery by comparing the target resistance with a first resistance profile P1 in which the target resistance of the battery calculated in the previous charging cycle is stored.

Specifically, the first resistance profile P1 is a profile in which the target resistance of the battery calculated in each past charging cycle is stored. For example, assuming that the current cycle is the n^{th} cycle, the target resistance calculated in the first to n-1^{th} cycles may be stored in the first resistance profile P1. Also, if the battery state diagnosis for the n^{th} cycle is completed, the target resistance calculated in the n^{th} cycle may be stored in the first resistance profile P1.

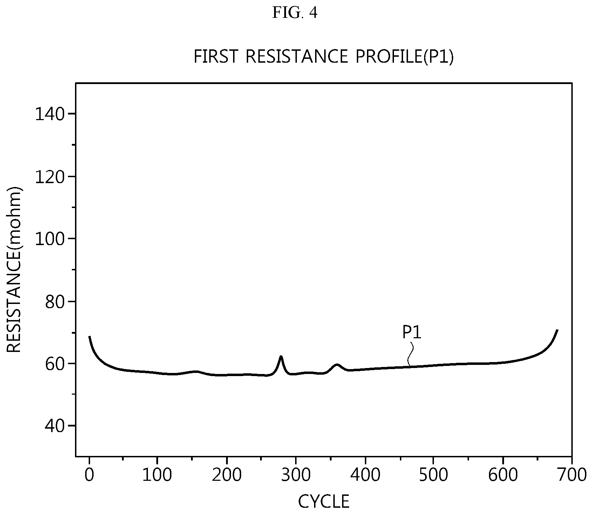

FIG. 4 is a diagram schematically showing the first resistance profile P1 according to an embodiment of the present disclosure. In the embodiment of FIG. 4, the first resistance profile P1 may be expressed as an X-Y graph in which the X-axis is set to cycle and the Y-axis is set to resistance.

The control unit 120 may be configured to determine the first resistance section R1 based on the first resistance profile P1.

First, the control unit 120 may be configured to determine a first resistance line L1 for a plurality of resistances included in the first resistance profile P1.

For example, the control unit 120 may determine the first resistance line L1 for the first resistance profile P1 through regression analysis. Here, the first resistance line L1 may be linear or nonlinear.

As another example, the control unit 120 may determine the first resistance line L1 by considering the regression analysis result of a preset first reference resistance line and the first resistance profile P1 together. Here, the first reference resistance line is a resistance line derived from the first resistance profile P1 of a pre-designed reference battery. That is, the reference battery is a battery pre-designed in a normal state, and the first reference resistance line is a resistance line that may be applied to the battery in the normal state. Therefore, the control unit 120 may determine the first resistance line L1 corresponding to the first resistance profile P1 by grafting the first reference resistance line onto the regression analysis result of the first resistance profile P1.

Preferably, the control unit 120 may determine the first resistance line L1 for the first resistance profile P1 through regression analysis.

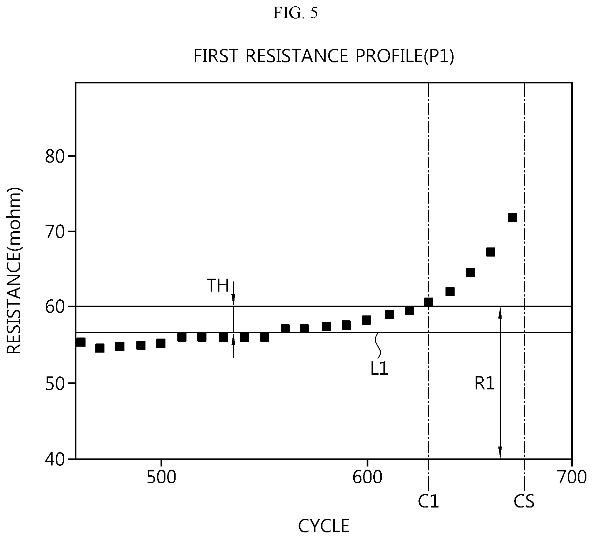

FIG. 5 is an enlarged view showing the first resistance profile P1 of FIG. 4. In the embodiment of FIG. 5, the control unit 120 may determine a first resistance line L1 of the first resistance profile P1.

The control unit 120 may be configured to determine the first resistance section R1 by adding a preset resistance threshold value to the determined first resistance line L1.

Specifically, the control unit 120 may adjust the first resistance line L1 by adding a preset resistance threshold value to the cycle-by-cycle resistance value according to the first resistance line L1. In addition, the control unit 120 may determine a resistance section lower than or equal to the adjusted first resistance line L1 as the first resistance section R1.

For example, in the embodiment of FIG. 5, the control unit 120 may move the first resistance line L1 parallel to the Y-axis by adding a resistance threshold value TH to the cycle-by-cycle resistance value of the first resistance line L1. In addition, the control unit 120 may determine the resistance section lower than or equal to the first resistance line L1 as the first resistance section R1.

In addition, the control unit 120 may be configured to diagnose the state of the battery by comparing the first resistance section R1 with the target resistance.

Specifically, the control unit 120 may diagnose the state of the battery depending on whether the target resistance belongs to the first resistance section R1.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

For example, the control unit 120 may be configured to diagnose the state of the battery as a normal state if the target resistance belongs to the first resistance section R1.

As another example, the control unit 120 may be configured to diagnose the state of the battery as an abnormal state if the target resistance does not belong to the first resistance section R1.

Here, the normal state means a state in which sudden death is unlikely to occur. Also, the abnormal state means a state in which sudden death is highly predicted to occur. In other words, a battery diagnosed as being in an abnormal state may be a battery in which sudden death is very likely to occur.

In general, when rapid charging is performed frequently, lithium plating phenomenon, in which lithium metal is deposited on the surface of the negative electrode, may occur more frequently than when normal charging is performed. In addition, since internal short circuit, fire, explosion, or sudden death that may occur due to lithium plating may occur suddenly, it is important to identify the warning symptoms in advance.

In particular, before sudden death occurs, the liquid diffusion resistance of lithium ions may increase significantly as byproducts accumulate at the interface between the negative electrode and the separator, clogging the pores of the separator and depleting the electrolyte. Since an increase in the liquid diffusion resistance is indicated by an increase in the target resistance, the control unit 120 may determine the possibility of sudden death of the battery based on whether the target resistance belongs to the first resistance section R1.

For example, in the embodiment of FIG. 5, the target resistance of the battery from the C1 cycle does not belong to the first resistance section R1. Therefore, the control unit 120 may diagnose the state of the battery as an abnormal state from the C1 cycle.

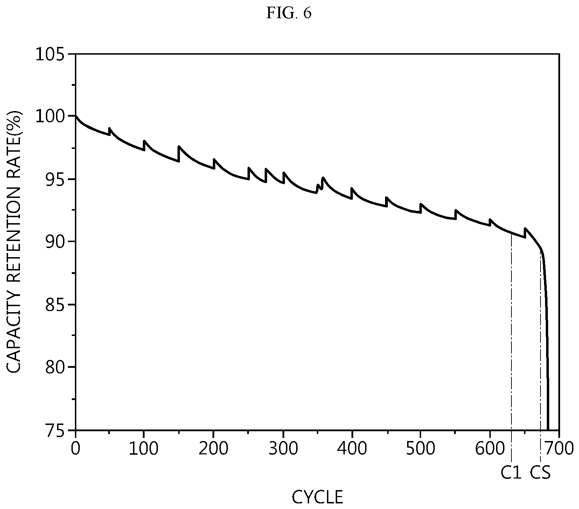

FIG. 6 is a diagram schematically showing a capacity retention rate of a battery according to an embodiment of the present disclosure. Specifically, referring to FIG. 6, in the CS cycle, the battery experiences suddenly death and the capacity retention rate is dropped sharply to 75% or less. Since sudden death occurs suddenly in this way, the apparatus 100 for diagnosing a battery may predict and diagnose the possibility of sudden death in advance based on the behavior of target resistance.

Meanwhile, the control unit 120 included in the apparatus 100 for diagnosing a battery optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store various information used for diagnosing the state of the battery, such as the charging profile CP, the first resistance profile P1, the first resistance line L1, the resistance threshold value TH, and the first resistance section R1.

Hereinafter, an embodiment in which the control unit 120 calculates the target resistance when the SOC at the start of charging of the battery is not constant for each cycle will be described.

The control unit 120 may be configured to calculate the initial resistance based on the voltage change amount and the charging current of the charging process.

In addition, the control unit 120 may be configured to compare the initial SOC of the battery just before charging begins with a preset target SOC.

Specifically, the target SOC may be preset to any one of the available SOC sections of the battery. For example, the target SOC may be preset to 10% of the SOC.

Depending on the situation in which the battery is used, the initial SOC of the battery just before charging begins may vary. For example, in the n^{th} cycle, the battery may be charged from 8% SOC, and in the n+1^{th} cycle, the battery may be charged from 15% SOC. Therefore, in order to more accurately calculate the target resistance, the control unit 120 may compare the initial SOC of the battery and the target SOC in the current cycle.

The control unit 120 may be configured to calculate the target resistance based on the initial resistance according to the comparison result.

Specifically, the control unit 120 may calculate the target resistance in different ways when the initial SOC is equal to the target SOC and when the initial SOC is different from the target SOC.

First, if the initial SOC is equal to the target SOC, the control unit 120 may be configured to determine the initial resistance as the target resistance.

Specifically, the control unit 120 may be configured to calculate a voltage change amount by calculating a difference between the initial voltage of the battery just before charging starts and the voltage of the battery immediately after charging starts. Also, the control unit 120 may calculate the initial resistance by dividing the calculated voltage change amount by the charging current. Finally, the control unit 120 may determine the calculated initial resistance as the target resistance of the battery.

Next, if the initial SOC is different from the target SOC, the control unit 120 may be configured to calculate the target resistance from the initial resistance based on a resistance table T preset to indicate a resistance ratio for each SOC.

Specifically, the control unit 120 may convert the initial resistance corresponding to the initial SOC into the target resistance corresponding to the target SOC based on the preset resistance table T.

More specifically, the control unit 120 may be configured to calculate the total resistance for the battery by dividing the initial resistance by a resistance ratio corresponding to the initial SOC in the resistance table T. In addition, the control unit 120 may be configured to determine the target resistance for the battery by multiplying the calculated total resistance by a resistance ratio corresponding to the target SOC in the resistance table T.

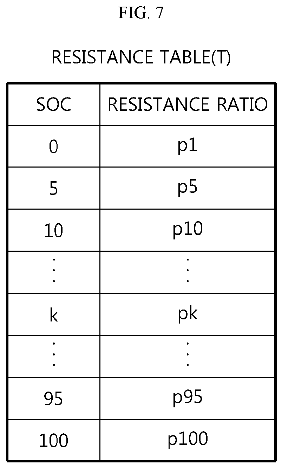

FIG. 7 is a diagram schematically showing the resistance table T according to an embodiment of the present disclosure. In the embodiment of FIG. 7, the sum of the resistance ratios of p1 to p100 is 1 or 100%.

Meanwhile, in the embodiment of FIG. 7, the resistance table T is set at 5% SOC intervals, but the SOC interval in the resistance table T may be applied without limitation. Moreover, the resistance ratio for the SOC (e.g., 3%) not included in the resistance table T may be interpolated and utilized based on the resistance ratios (p1 and p5) of adjacent SOCs (e.g., 0% and 5%).

In the embodiment of FIG. 7, it is assumed that the preset target SOC is 10%, the initial SOC of the battery is k%, and the initial resistance is R. The control unit 120 may calculate the total resistance of the battery by dividing the initial resistance R by the resistance ratio pk of the initial SOC. For example, the control unit 120 may calculate the total resistance of the battery by calculating the formula "R÷pk". In addition, the control unit 120 may determine the target resistance of the battery by multiplying the total resistance of the battery by the resistance ratio p10 of the target SOC. For example, the control unit 120 may calculate the total resistance of the battery by calculating the formula "R÷pk×p10".

That is, the control unit 120 may convert the initial resistance R corresponding to the initial SOC k (%) into the target resistance (R÷pk×p10) corresponding to the target SOC 10 (%). Also, the control unit 120 may diagnose the state of the battery based on the result of comparing the target resistance and the first resistance section R1.

The apparatus 100 for diagnosing a battery according to an embodiment of the present disclosure may determine a target resistance by considering a situation where the initial SOC of the battery is not constant, and diagnose the state of the battery according to the determined target resistance. That is, the apparatus 100 for diagnosing a battery has an advantage of diagnosing the state of the battery even in a situation where the initial SOC of the battery is not constant for each cycle, by determining the target resistance using the resistance table T.

Hereinafter, an embodiment in which the control unit 120 supplementarily diagnoses the state of the battery by further considering a sub-resistance will be described.

The control unit 120 may be configured to calculate the sub-voltage change amount between the voltage of the battery immediately after charging starts in the charging profile CP and the voltage at the point in time when charging is performed for a preset time.

Specifically, the preset time may be determined within the period from the start of charging to the time when charging is performed with the same charging C-rate. For example, the preset time may be 30 seconds.

For example, in the embodiment of FIG. 3, the initial voltage of the battery just before charging starts is V1, the voltage of the battery immediately after charging starts is V2, and the voltage of the battery at the point in time when charging is performed for a preset time is V3. The control unit 120 may calculate the formula of "V3-V2" to derive the sub-voltage change amount of the battery.

The control unit 120 may be configured to calculate the sub-resistance of the battery based on the calculated sub-voltage change amount.

For example, in the embodiments of FIGS. 2 and 3, it is assumed that the charging current for the SOC section of S1 (%) to S2 (%) is I. The control unit 120 may calculate the value obtained by dividing the sub-voltage change amount (V3-V2) by the charging current (I) as the sub-resistance.

The control unit 120 may be configured to diagnose the state of the battery based on the target resistance and the sub-resistance.

The control unit 120 may be configured to determine the second resistance section R2 based on a second resistance profile P2 in which the sub-resistance of the battery calculated in a previous charging cycle is stored.

Specifically, the second resistance profile P2 is a profile in which the sub-resistance of the battery calculated in each past charging cycle is stored. For example, assuming that the current cycle is the n^{th} cycle, the sub-resistance calculated for the first to n-1^{th} cycles may be stored in the second resistance profile P2. Also, if the battery state diagnosis for the n^{th} cycle is completed, the sub-resistance calculated in the n^{th} cycle may be stored in the second resistance profile P2.

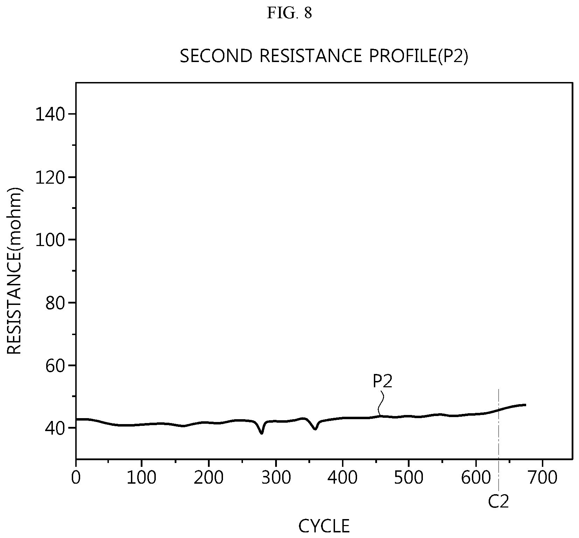

FIG. 8 is a diagram schematically showing the second resistance profile P2 according to an embodiment of the present disclosure. In the embodiment of FIG. 8, the second resistance profile P2 may be expressed as an X-Y graph in which the X-axis is set to cycle and the Y-axis is set to resistance.

The control unit 120 may be configured to determine a second resistance line L2 for a plurality of resistances included in the second resistance profile P2.

For example, the control unit 120 may determine the second resistance line L2 for the second resistance profile P2 through regression analysis. Here, the second resistance line L2 may be linear or nonlinear.

As another example, the control unit 120 may determine the second resistance line L2 by considering the regression analysis result of a preset second reference resistance line and the second resistance profile P2 together. Here, the second reference resistance line is a resistance line derived from the second resistance profile P2 of a pre-designed reference battery. That is, the reference battery is a battery pre-designed in a normal state, and the second reference resistance line is a resistance line that may be applied to the battery in the normal state. Therefore, the control unit 120 may determine the second resistance line L2 corresponding to the second resistance profile P2 by grafting the second reference resistance line onto the regression analysis result of the second resistance profile P2.

Preferably, the control unit 120 may determine the second resistance line L2 for the second resistance profile P2 through regression analysis.

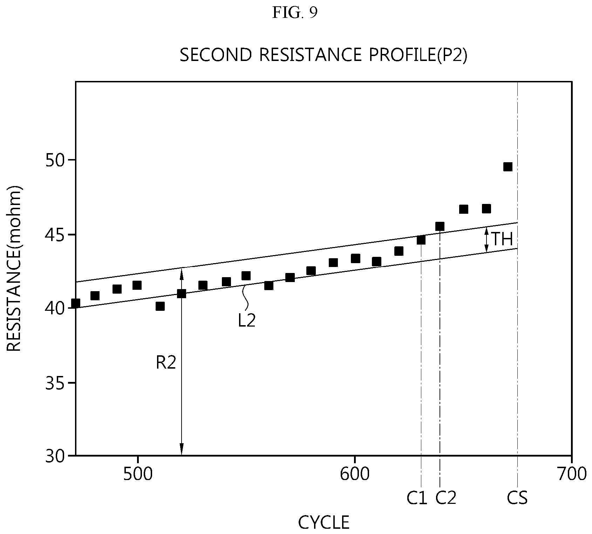

FIG. 9 is an enlarged view showing the second resistance profile P2 of FIG. 8. In the embodiment of FIG. 9, the control unit 120 may determine the second resistance line L2 of the second resistance profile P2.

The control unit 120 may be configured to determine the second resistance section R2 by adding a preset resistance threshold value to the determined second resistance line L2. Specifically, the control unit 120 may determine the second resistance section R2 by adding a resistance threshold value to the second resistance line L2 in the same way as the first resistance section R1 is determined by adding a resistance threshold value to the first resistance line L1. Here, the resistance threshold value added to the first resistance line L1 and the resistance threshold value added to the second resistance line L2 may be the same or different.

For example, in the embodiment of FIG. 9, the control unit 120 may move the second resistance line L2 parallel to the Y-axis by adding a resistance threshold value TH to the cycle-by-cycle resistance value of the second resistance line L2. In addition, the control unit 120 may determine the resistance section less than or equal to the second resistance line L2 as the second resistance section R2.

In addition, the control unit 120 may be configured to diagnose the state of the battery based on the result of comparing the first resistance section R1 with the target resistance and the result of comparing the second resistance section R2 with the sub-resistance.

Specifically, the control unit 120 may diagnose the state of the battery based on whether the target resistance belongs to the first resistance section R1 and whether the sub-resistance belongs to the second resistance section R2.

First, if the resistance value of the target resistance is lower than or equal to the resistance value of the first resistance line L1, the control unit 120 may determine that the target resistance belongs to the first resistance section R1. Conversely, if the resistance value of the target resistance exceeds the resistance value of the first resistance line L1, the control unit 120 may determine that the target resistance does not belong to the first resistance section R1.

Next, if the resistance value of the sub-resistance is lower than or equal to the resistance value of the second resistance line L2, the control unit 120 MAY determine that the sub-resistance belongs to the second resistance section R2. Conversely, if the resistance value of the sub-resistance exceeds the resistance value of the second resistance line L2, the control unit 120 MAY determine that the sub-resistance does not belong to the second resistance section R2.

For example, the control unit 120 MAY be configured to diagnose the state of the battery as a normal state if the target resistance belongs to the first resistance section R1 or if the sub-resistance belongs to the second resistance section R2.

As another example, the control unit 120 may be configured to diagnose the state of the battery as an abnormal state if the target resistance does not belong to the first resistance section R1 and the sub-resistance does not belong to the second resistance section R2.

That is, the control unit 120 may diagnose the state of the battery as an abnormal state only when the target resistance does not belong to the first resistance section R1 and the sub-resistance does not belong to the second resistance section R2.

For example, in the embodiments of FIGS. 5, 6, and 9, the target resistance in the C1 cycle does not belong to the first resistance section R1, but the sub-resistance belongs to the second resistance section R2. That is, if only the target resistance is considered, the state of the battery in the C1 cycle is diagnosed as an abnormal state, but if both the target resistance and the sub-resistance are considered, the state of the battery in the C1 cycle is diagnosed as a normal state. Also, the target resistance in the C2 cycle does not belong to the first resistance section R1, and the sub-resistance does not belong to the second resistance section R2. That is, the state of the battery in the C2 cycle is diagnosed as an abnormal state. Also, sudden death occurs in the battery in the CS cycle after the C2 cycle.

If the target resistance is used, the possibility of sudden death of the battery may be diagnosed earlier than when the sub-resistance is used. For example, the first cycle (e.g., C1) in which the target resistance does not belong to the first resistance section R1 precedes the first cycle (e.g., C2) in which the sub-resistance does not belong to the second resistance section R2.

However, since sudden death means a state in which the internal resistance of the battery increases rapidly and the battery cannot be charged or discharged, the state of the battery should be diagnosed as an abnormal state from a conservative and strict point of view. If the state of the battery is diagnosed by considering only the target resistance, the state of the battery may be misdiagnosed, and since the state of the battery is diagnosed as an abnormal state earlier than the case where the sub-resistance is further considered, the period during which the battery can be used is shortened.

Therefore, the apparatus 100 for diagnosing a battery according to an embodiment of the present disclosure may diagnose the state of the battery more accurately by considering the sub-resistance in addition to the target resistance. Moreover, the apparatus 100 for diagnosing a battery may increase the expected life of the battery by considering both the target resistance and the sub-resistance.

The apparatus 100 for diagnosing a battery according to the present disclosure can be applied to the BMS. In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the profile obtaining unit 110, the control unit 120 and the storage unit 130 of the apparatus 100 for diagnosing a battery may be implemented as components of a BMS.

Additionally, the apparatus 100 for diagnosing a battery according to the present disclosure may be provided in the battery pack 10. That is, the battery pack according to the present disclosure may include the above-described apparatus 100 for diagnosing a battery and at least one battery cell. Additionally, the battery pack may further include electrical components (relays, fuses, etc.) and a case.

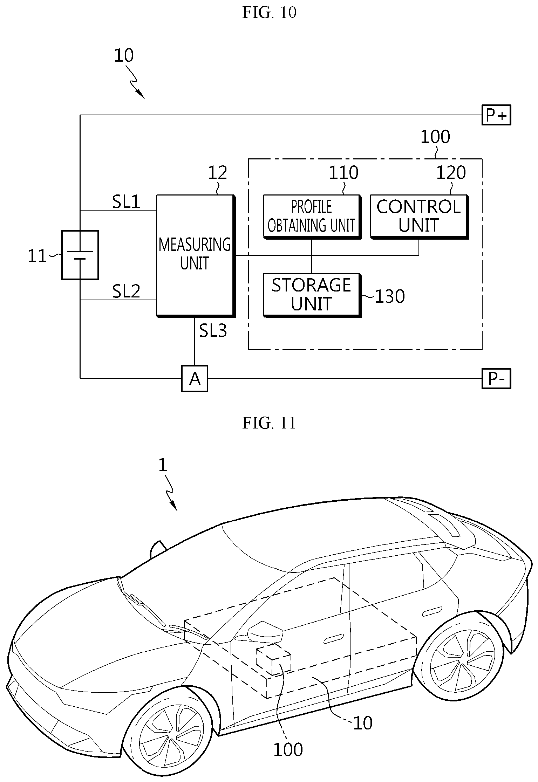

FIG. 10 is a diagram schematically showing a battery pack including according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to a first sensing line SL1, a second sensing line SL2, and a third sensing line SL3. Specifically, the measuring unit 12 may be connected to the positive electrode terminal of the battery 11 through the first sensing line SL1, and connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 can be connected to a current measurement unit A through the third sensing line SL3. For example, the current measurement unit A may be an ammeter or shunt resistor that can measure the charging current and discharging current of the battery 11. The measuring unit 12 may calculate the charging amount by measuring the charging current of the battery 11 through the third sensing line SL3. Additionally, the measuring unit 12 can calculate the discharge amount by measuring the discharge current of the battery 11 through the third sensing line SL3.

For example, the profile obtaining unit 110 may receive battery information about the voltage and current of the battery from the measuring unit 12. Then, the profile obtaining unit 110 may generate a charging profile CP based on the battery information.

As another example, the profile obtaining unit 110 may receive a charging profile CP from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 11 is a diagram schematically showing a vehicle 1 according to still another embodiment of the present disclosure.

Referring to FIG. 11, the battery pack 10 according to an embodiment of the present disclosure may be included in a vehicle 1 such as an electric vehicle (EV) or a hybrid vehicle (HV). In addition, the battery pack 10 may drive the vehicle 1 by supplying power to a motor through an inverter included in the vehicle 700. Here, the battery pack 10 may include the apparatus 100 for diagnosing a battery. That is, the vehicle 1 may include the apparatus 100 for diagnosing a battery. In this case, the apparatus 100 for diagnosing a battery may be an on-board device included in the vehicle 1.

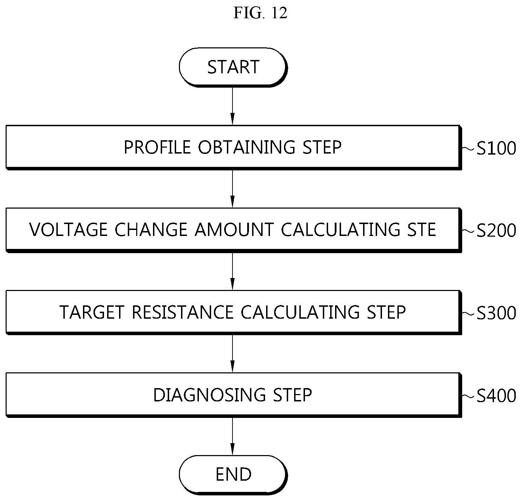

FIG. 12 is a diagram for schematically illustrating a method for diagnosing a battery according to still another embodiment of the present disclosure.

Referring to FIG. 12, the method for diagnosing a battery may include a profile obtaining step (S100), a voltage change amount calculating step (S200), a target resistance calculating step (S300), and a diagnosing step (S400).

Preferably, each step of the method for diagnosing a battery can be performed by the apparatus 100 for diagnosing a battery. Hereinafter, for convenience of explanation, content that overlaps with the content described above will be omitted or briefly described.

The profile obtaining step (S100) is a step of obtaining a charging profile CP representing a voltage change of a battery in a charging process, and may be performed by the profile obtaining unit 110.

For example, the profile obtaining unit 110 may directly receive the charging profile CP from the outside. That is, the profile obtaining unit 110 may obtain the charging profile CP by receiving the charging profile CP by being connected to the outside wired and/or wirelessly.

As another example, the profile obtaining unit 110 may receive battery information about the voltage and SOC of the battery. Additionally, the profile obtaining unit 110 may generate a charging profile CP based on the received battery information. That is, the profile obtaining unit 110 may obtain the charging profile CP by directly generating the charging profile CP based on the battery information.

The voltage change amount calculating step (S200) is a step of calculating a voltage change amount of the battery at a point in time when charging starts in the charging profile CP, and may be performed by the control unit 120.

For example, the control unit 120 may be configured to calculate the voltage change amount by calculating the difference between the initial voltage of the battery just before charging begins and the voltage of the battery immediately after charging begins.

The target resistance calculating step (S300) is a step of calculating a target resistance of the battery based on the calculated voltage change amount, and may be performed by the control unit 120.

The control unit 120 may be configured to calculate the target resistance based on the voltage change amount and the charging current of the charging process.

For example, in the embodiments of FIGS. 2 and 3, it is assumed that the charging current for the SOC section of S1 (%) to S2 (%) is I. The control unit 120 may calculate the value obtained by dividing the voltage change amount (V2-V1) by the charging current (I) as the target resistance.

The diagnosing step (S400) is a step for diagnosing the state of the battery by comparing the target resistance with a first resistance profile P1 in which the target resistance of the battery calculated in a previous charging cycle is stored, and may be performed by the control unit 120.

The control unit 120 may be configured to determine the first resistance section R1 based on the first resistance profile P1.

In addition, the control unit 120 may be configured to diagnose the state of the battery by comparing the first resistance section R1 with the target resistance. For example, the control unit 120 may be configured to diagnose the state of the battery as a normal state if the target resistance belongs to the first resistance section R1. As another example, the control unit 120 may be configured to diagnose the state of the battery as an abnormal state if the target resistance does not belong to the first resistance section R1.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Reference Signs)

1: vehicle
10: battery pack
11: battery
12: measuring unit
100: apparatus for diagnosing a battery
110: profile obtaining unit
120: control unit
130: storage unit

## Claims

1. An apparatus for diagnosing a battery, comprising:
a profile obtaining unit configured to obtain a charging profile representing a voltage change of a battery in a charging process; and
a control unit configured to calculate a voltage change amount of the battery at a point in time when charging starts in the charging profile, calculate a target resistance of the battery based on the calculated voltage change amount, and diagnose a state of the battery by comparing the target resistance with a first resistance profile in which a target resistance of the battery calculated in a previous charging cycle is stored.

2. The apparatus for diagnosing a battery according to claim 1,
wherein the control unit is configured to determine a first resistance section based on the first resistance profile and diagnose the state of the battery by comparing the first resistance section with the target resistance.

3. The apparatus for diagnosing a battery according to claim 2,
wherein the control unit is configured to determine a first resistance line for a plurality of resistances included in the first resistance profile and determine the first resistance section by adding a preset resistance threshold value to the determined first resistance line.

4. The apparatus for diagnosing a battery according to claim 2,
wherein the control unit is configured to diagnose the state of the battery as a normal state when the target resistance belongs to the first resistance section, and
wherein the control unit is configured to diagnose the state of the battery as an abnormal state when the target resistance does not belong to the first resistance section.

5. The apparatus for diagnosing a battery according to claim 2,
wherein the control unit is configured to calculate a sub-voltage change amount between a voltage of the battery immediately after the charging starts and a voltage at a point in time when the charging is performed for a preset time in the charging profile, calculate a sub-resistance of the battery based on the calculated sub-voltage change amount, and diagnose the state of the battery based on the target resistance and the sub-resistance.

6. The apparatus for diagnosing a battery according to claim 5,
wherein the control unit is configured to determine a second resistance section based on a second resistance profile in which a sub-resistance of the battery calculated at the previous charging cycle is stored and diagnose the state of the battery based on the result of comparing the first resistance section with the target resistance and the result of comparing the second resistance section with the sub-resistance.

7. The apparatus for diagnosing a battery according to claim 6,
wherein the control unit is configured to determine a second resistance line for a plurality of resistances included in the second resistance profile and determine the second resistance section by adding a preset resistance threshold value to the determined second resistance line.

8. The apparatus for diagnosing a battery according to claim 6,
wherein the control unit is configured to diagnose the state of the battery as a normal state when the target resistance belongs to the first resistance section or the sub-resistance belongs to the second resistance section, and
wherein the control unit is configured to diagnose the state of the battery as an abnormal state when the target resistance does not belong to the first resistance section and the sub-resistance does not belong to the second resistance section.

9. The apparatus for diagnosing a battery according to claim 1,
wherein the control unit is configured to calculate the voltage change amount by calculating a difference between an initial voltage of the battery just before the charging starts and a voltage of the battery immediately after the charging starts.

10. The apparatus for diagnosing a battery according to claim 9,
wherein the control unit is configured to calculate an initial resistance based on the voltage change amount and a charging current of the charging process, compare an initial SOC of the battery just before the charging starts with a preset target SOC, and calculate the target resistance based on the initial resistance according to the comparison result.

11. The apparatus for diagnosing a battery according to claim 10,
wherein the control unit is configured to determine the initial resistance as the target resistance when the initial SOC is equal to the target SOC, and
wherein the control unit is configured to calculate the target resistance from the initial resistance based on a resistance table preset to indicate a resistance ratio for each SOC, when the initial SOC is different from the target SOC.

12. The apparatus for diagnosing a battery according to claim 11,
wherein the control unit is configured to calculate a total resistance for the battery by dividing the initial resistance by a resistance ratio corresponding to the initial SOC in the resistance table and determine the target resistance for the battery by multiplying the total resistance by a resistance ratio corresponding to the target SOC in the resistance table.

13. A battery pack comprising the apparatus for diagnosing a battery according to any one of claims 1 to 12.

14. A vehicle comprising the apparatus for diagnosing a battery according to any one of claims 1 to 12.

15. A method for diagnosing a battery, comprising:
a profile obtaining step of obtaining a charging profile representing a voltage change of a battery in a charging process;
a voltage change amount calculating step of calculating a voltage change amount of the battery at a point in time when charging starts in the charging profile;
a target resistance calculating step of calculating a target resistance of the battery based on the calculated voltage change amount; and
a diagnosing step of diagnosing a state of the battery by comparing the target resistance with a first resistance profile in which a target resistance of the battery calculated in a previous charging cycle is stored.
